(19) Europäisches Patentamt
European Patent Office
Office européen des brevets

(11) **EP 4 089 584 B1**

(12) **EUROPEAN PATENT SPECIFICATION**

(45) Date of publication and mention of the grant of the patent:
**12.02.2025 Bulletin 2025/07**

(21) Application number: **21305599.9**

(22) Date of filing: **10.05.2021**

(51) International Patent Classification (IPC):
*G06N 3/063* (2023.01)   *G06N 3/00* (2023.01)
*G06N 3/08* (2023.01)   *G06N 7/00* (2023.01)

(52) Cooperative Patent Classification (CPC):
**G06N 3/084; G06N 3/006; G06N 3/065; G06N 7/01**

(54) **DEVICE AND METHOD FOR TD-LAMBDA TEMPORAL DIFFERENCE LEARNING WITH A VALUE FUNCTION NEURAL NETWORK**

VORRICHTUNG UND VERFAHREN FÜR ZEITLICHES TD-LAMBDA-DIFFERENZLERNEN MIT EINEM NEURONALEN WERTEFUNKTIONSNETZ

DISPOSITIF ET PROCÉDÉ D'APPRENTISSAGE DE DIFFÉRENCE TEMPORELLE TD-LAMBDA AVEC UN RÉSEAU NEURONAL À FONCTION DE VALEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**16.11.2022 Bulletin 2022/46**

(73) Proprietor: **Commissariat à l'Energie Atomique et aux Energies Alternatives**
**75015 Paris (FR)**

(72) Inventors:
• **VIANELLO, Elisa**
  **38054 Grenoble Cedex 09 (FR)**
• **DALGATY, Thomas**
  **38054 Grenoble Cedex 09 (FR)**

(74) Representative: **Cabinet Beaumont**
**4, Place Robert Schuman**
**B.P. 1529**
**38025 Grenoble Cedex 1 (FR)**

(56) References cited:
• **GIT DEMIRA&BREVE; YI&BREVE; ET AL: "PCM-trace: Scalable Synaptic Eligibility Traces with Resistivity Drift of Phase-Change Materials", 16 February 2021 (2021-02-16), XP055849893, Retrieved from the Internet <URL:https://arxiv.org/pdf/2102.07260.pdf> [retrieved on 20211011]**
• **IREM BOYBAT ET AL: "Neuromorphic computing with multi-memristive synapses", ARXIV.ORG, CORNELL UNIVERSITY LIBRARY, 201 OLIN LIBRARY CORNELL UNIVERSITY ITHACA, NY 14853, 17 November 2017 (2017-11-17), XP080838104**
• **KIM JANGSAENG ET AL: "On-chip trainable hardware-based deep Q-networks approximating a backpropagation algorithm", NEURAL COMPUTING AND APPLICATIONS, SPRINGER LONDON, LONDON, vol. 33, no. 15, 10 February 2021 (2021-02-10), pages 9391 - 9402, XP037501599, ISSN: 0941-0643, [retrieved on 20210210], DOI: 10.1007/S00521-021-05699-Z**

**Description**

Technical field

The present disclosure relates generally to the field of machine learning, and in particular to a method and device for "TD-lambda" temporal difference learning in a neural network approximating a value function.

Background art

Reinforcement learning involves the use of a machine, referred to as an agent, that is trained to learn a policy for generating actions to be applied to an environment. The agent applies the actions to the environment, and in response, the environment returns its state and a reward associated with the action to the agent.

It has been proposed to implement the agent using an artificial neural network, such an approach being known as deep reinforcement learning.

In many types of environments, there is a delay between a given action and its associated reward. A type of solution known as temporal difference (TD) learning has been developed in order to train agents for such environments. According to TD learning, the time aspect is taken into account during the learning of the policy in order to develop temporal connections between actions and delayed rewards - known as the temporal credit assignment problem. According to TD learning, eligibility is assigned to recently visited states in a discrete Markov decision process in order to update a value function of the model. The value is a quantity that corresponds to the expected future discounted reward as a result of being in a certain state. There are several forms of value function. For example, the function V(s), based on the value of being in a possible state, was used in Tesauro, Gerald, "TD-Gammon, a self-teaching backgammon program, achieves master-level play" Neural computation 6.2 (1994): 215-219. Actions were selected by choosing, from all of the possible next states, that which resulted in the largest value function output. Another function Q(s,a), also known as Q-learning, uses the future discounted reward of taking certain actions given a current state as applied to temporal difference learning in Mousavi, Seyed Sajad, et al. "Applying q ($\lambda$)-learning in deep reinforcement learning to play atari games" AAMAS Adaptive Learning Agents (ALA) Workshop, 2017. Using the function Q(s,a) involves only a presentation of the current state and the selection of the optimal action in that state to transition to the next state. The publication by Yigit Demirag et al. entitled "PCM-trace: Scalable Synaptic Eligibility Traces with Resistivity Drift of Phase-Change Materials", 16 February 2021, relates to scalable synaptic eligibility traces with resistivity drift of phase-change materials.

There is, however, a technical difficulty in implementing TD-lambda learning, with a neural network approximating the value function, in a device in a simple and cost-effective manner.

Summary of Invention

It is an aim of embodiments of the present disclosure to at least partially address one or more difficulties in the prior art. The invention is set out in the appended set of claims.

According to one aspect, there is provided a synapse circuit of a neural network for performing TD-lambda temporal difference learning, the neural network approximating a value function, the synapse circuit comprising: a first resistive memory device; a second resistive memory device; and a synapse control circuit configured to update a synaptic weight of the synapse circuit by programming a resistive state of the first resistive memory device based on a programmed conductance of the second resistive memory device.

According to one embodiment, the second resistive memory device is configured to have a conductance that decays over time.

According to one embodiment, the second resistive memory device is a phase-change memory device or a conductive bridging RAM element.

According to one embodiment, the synapse control circuit is further configured to update an eligibility trace of the synapse circuit by programming a resistive state of the second resistive memory device based on a back-propagated derivative of an output value of the neural network.

According to one embodiment, the synapse control circuit is configured to update the synaptic weight by applying a voltage or current level generated based on a temporal difference error to an electrode of the second resistive memory device to generate an output current or voltage level.

According to one embodiment, the synapse control circuit is further configured to compare the output current or voltage level with one or more thresholds, and to program the resistive state of the first resistive memory device based on the comparison.

According to a further aspect, there is provided an agent device of a TD-lambda temporal difference learning system, the agent device comprising a neural network comprising an input layer of neurons, one or more hidden layers of neurons, and an output layer of neurons, wherein:

- each neuron of the input layer is coupled to one or more neurons of a first hidden layer of the one or more hidden layers via a corresponding synapse circuit implemented by the above circuit.

According to one embodiment, the agent device further comprises a control circuit configured to generate the temporal difference error based on a reward signal received from the environment, and to provide the temporal difference error to the neural network.

According to one embodiment, the control device provides to the neural network a signal representative of the product of the temporal difference error and a learning rate.

According to a further aspect, there is provided a system for TD-lambda temporal difference learning comprising:

- the above agent device configured to generate an output signal indicating an action to be applied to an environment based on an output of the neural network;
- one or more actuators configured to apply the action to the environment; and
- one or more sensors configured to detect a state of the environment and a reward resulting from the action.

According to a further aspect, there is provided a method of TD-lambda temporal difference learning, the method comprising:

- updating a synaptic weight of a synapse circuit of a neural network, the neural network approximating a value function, the synapse circuit comprising: a first resistive memory device; a second resistive memory device; and a synapse control circuit, wherein updating the synaptic weight comprises programming, by the synapse control circuit, a resistive state of the first resistive memory device based on a programmed conductance of the second resistive memory device.

According to one embodiment, the second resistive memory device is configured to have a conductance that decays over time.

According to one embodiment, the method further comprises updating, by the synapse control circuit, an eligibility trace of the synapse circuit by programming a resistive state of the second resistive memory device based on a back-propagated derivative of an output value of the neural network.

According to one embodiment, updating the synaptic weight comprises applying a voltage or current level generated based on a temporal difference error to an electrode of the second resistive memory device in order to generate an output current or voltage level.

According to one embodiment, the method further comprises comparing, by the synapse control circuit, the output current or voltage level with one or more thresholds, and programming the resistive state of the first resistive memory device based on the comparison.

Brief description of drawings

The foregoing features and advantages, as well as others, will be described in detail in the following description of specific embodiments given by way of illustration and not limitation with reference to the accompanying drawings, in which:

Figure 1 schematically illustrates a system for reinforcement learning according to an example embodiment of the present disclosure;

Figure 2 schematically illustrates the system of Figure 1 in more detail according to an example embodiment;

Figure 3 is a flow diagram illustrating an example of operations in a method of TD-lambda temporal difference learning according to an example embodiment of the present disclosure;

Figure 4 schematically illustrates a deep neural network according to an example embodiment of the present disclosure;

Figure 5 illustrates an array of synapse circuits interconnecting layers of a deep neural network according to an example embodiment of the present disclosure;

Figure 6 is a graph illustrating an example of conductance drift of a phase change memory (PCM) device over time;

Figure 7 is a graph illustrating, on a logarithmic scale, an example of resistance drift of a phase-change memory device over time;

Figure 8 schematically illustrates an agent of Figures 1 and 2 in more detail according to an example embodiment of the present disclosure;

Figure 9 schematically illustrates a synapse circuit in more detail according to an example embodiment;

Figure 10A is a flow diagram illustrating operations in a method of storing an eligibility trace according to an example embodiment of the present disclosure;

Figure 10B is a timing diagram representing variation of a conductance of a resistive memory device storing an eligibility trace according to an example embodiment of the present disclosure;

Figure 10C is a flow diagram illustrating operations in a method of storing a synaptic weight according to an example embodiment of the present disclosure;

Figure 10D is a timing diagram representing stored values of a synaptic weight according to an example embodiment of the present disclosure; and

Figure 11 is a cross-section view illustrating a transistor layer and metal stack forming part of a deep neural network according to an example embodiment of the present disclosure.

Description of embodiments

Like features have been designated by like references in the various figures. In particular, the structural and/or functional features that are common among the various embodiments may have the same references and may dispose identical structural, dimensional and material properties.

Unless indicated otherwise, when reference is made to two elements connected together, this signifies a direct connection without any intermediate elements other than conductors, and when reference is made to two elements coupled together, this signifies that these two elements can be connected or they can be coupled via one or more other elements.

In the following disclosure, unless indicated otherwise, when reference is made to absolute positional qualifiers, such as the terms "front", "back", "top", "bottom", "left", "right", etc., or to relative positional qualifiers, such as the terms "above", "below", "higher", "lower", etc., or to qualifiers of orientation, such as "horizontal", "vertical", etc., reference is made to the orientation shown in the figures.

Unless specified otherwise, the expressions "around", "approximately", "substantially" and "in the order of" signify within 10%, and preferably within 5%.

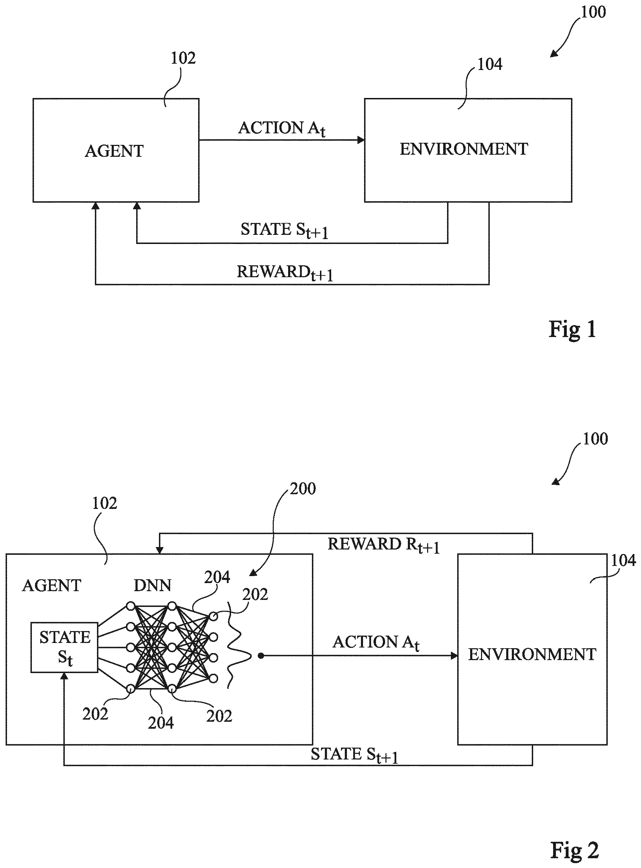

Figure 1 schematically illustrates a system 100 for reinforcement learning according to an example embodiment of the present disclosure. The system 100 comprises an agent (AGENT) 102, implemented for example by a data processing device, and an environment (ENVIRONMENT) 104, implemented for example by one or more actuators and one or more sensors. The agent 102 is for example configured to generate actions $A_t$ (ACTION $A_t$), and to apply these actions to the environment, and in particular to the one or more actuators of the environment. The one or more sensors for example generate signals representing a state $S_{t+1}$ (STATE $S_{t+1}$) and a reward $R_{t+1}$ (REWARD $R_{t+1}$) resulting from each action $A_t$. These state and reward signals are processed by the agent 102 in order to generate the next action $A_t$ to be applied to the environment.

During a learning phase, reinforcement learning is used in order for the agent to learn a policy for selecting actions based on the rewards received from the actions applied to the environment. The agent updates its policy as a function of the actions and the rewards in order to improve its future expected discounted reward. While there are many manners in which the policy implemented by the agent 102 can be described and updated, there is a recent trend towards the use of a deep neural network that acts as a policy approximation. Such solutions are known as deep reinforcement learning.

In some embodiments, the agent applies TD-lambda temporal difference learning. In such a case, the neural network maintains an internal representation of a value function V(s), which gives the value of being in each state in view of the current state. The neural network is configured to learn the value function V(s) based on the state information and on the rewards. For example, the policy is updated by iteratively differentiating the difference between the predicted and received value with respect to the synaptic weights of the current policy. This difference is known as the temporal difference (TD) error.

In other embodiments, the agent uses a function Q(s,a). In such a case, the neural network is configured to learn, based on the state information and on the rewards, a function Q that gives the value of each action that may be taken while in the current state. The training involves, for example, minimizing the difference (TD error) between the predicted Q-value, i.e. the one that resulted in a given action being taken, and the received reward plus the maximum Q value that is selected next as a function of the resulting state $S_{t+1}$.

Figure 2 schematically illustrates the system 100 of Figure 1 in more detail according to an example embodiment in which the agent 102 is implemented by an artificial neural network, such as a deep neural network (DNN) 200. The DNN 200 comprises a plurality of layers of neurons 202 interconnected by synapses 204. An input layer of the network for example receives the state $S_t$. The output layer of the neural network, which approximates a state-value function, is a scalar number corresponding to the predicted value of that state. Where the neural network approximates a state-action function, the output layer is the vector of possible actions $A_t$ (ACTION $A_t$). From this output vector, the corresponding action taken by the network can be deduced using the maximum argument. This action $A_t$ is then taken, which updates the environment.

For example, in one embodiment, the neural network implements a value function V(s), and the outputs indicate the value of being in a given state. A state-value network for example has one or more output neurons.

In state-action value functions Q(s,a), a neural network for example has multiple output neurons each of which corresponds to a different action that can be taken in that state. The highest output for example indicates the action that should be taken. A corresponding action $A_t$ is for example selected and applied to the environment in order to move to this next state.

The environment 104 provides the next state $S_{t+1}$ to the input of the DNN 200, and also supplies the reward $R_{t+1}$ to the agent 102, as will be described in more detail below.

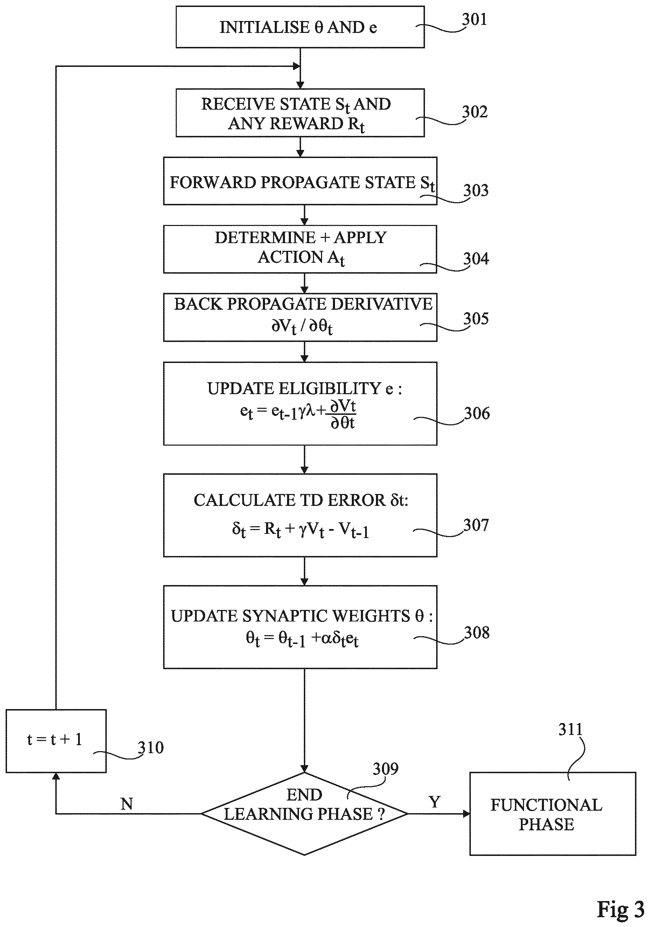

Figure 3 is a flow diagram illustrating an example of operations in a method of TD-lambda temporal difference learning according to an example embodiment of the present disclosure. This method is for example applied by the agent 102 of Figures 1 and 2.

In an operation 301 (INITIALISE $\theta$ and $e$), matrices $\theta$ and $e$ stored by the agent 102 are initialized. For example, the matrix $\theta$ corresponds to a parameter matrix of the DNN 200, defining the synaptic weights of the synapses of the DNN 200. The matrix $e$ corresponds for example to an eligibility matrix of the DNN 200, and defines for example, for each synapse, an eligibility trace of the synapse for use in updating the corresponding synaptic weight.

After the initialization operation 301, an iterative learning phase is for example entered, each iteration involving operations 302 to 310.

In the operation 302 (RECEIVE STATE $S_t$ AND ANY REWARD $R_t$), the agent 102 for example receives from the environment, at a timestep t, the state $S_t$ of the environment, and any reward $R_t$ occurring during the timestep t. Indeed, given that rewards may occur after a certain time delay with respect to actions, there may be no rewards received during some timesteps.

In the operation 303 (FORWARD PROPAGATE STATE $S_t$), a current state $S_t$ of the environment is forward propagated through the DNN 200. The state is thus modified by the parameter matrix $\theta$ of the DNN 200, and values $V_t$ at the output layer of the DNN 200 are thus generated.

In the operation 304 (DETERMINE + APPLY ACTION $A_t$), the action to be applied to the environment 104, based on the output values $V_t$ resulting from the state $S_t$, is determined and applied to the environment 104, for example via one or more actuators of the environment 104. For example, the action $A_t$ is one that is associated with a neuron of the output layer of the DNN 200 having the highest value.

In the operations 305 and 306, the eligibility matrix $e$ is for example updated based on the output values $V_t$ resulting from the forward propagation of the state $S_t$ in the operation 303.

In the operation 305 (BACK PROPAGATE DERIVATIVE $\partial V_t/\partial \theta_t$), the derivatives $\partial V_t/\partial \theta_t$ of the output values $V_t$ with respect to the model defined by the synaptic weights $\theta_t$ are backpropagated through the neural network. For each synapse, the derivative $\partial V_t/\partial \theta_t$ represents in particular how each synaptic weight $\theta$ impacts the calculation of the value function $V_t$. This is a different approach from a standard learning technique in a neural network, in which it is the derivative of the cost with respect to the model, or the loss with respect to the labelled output, that is back propagated through the network.

In the operation 306 (UPDATE ELIGIBILITY e), the derivative $\partial V_t/\partial \theta_t$ of each synapse is used to update the eligibility trace $e$ of the synapse. For example, the new eligibility value $e_t$ for timestep t is generated based on the following equation:

[Math 1]

$$e_t = e_{t-1}\gamma\lambda + \frac{\partial V_t}{\partial \theta_t}$$

where $e_{t-1}$ is the previous value of the eligibility trace at the timestep t-1, $\gamma$ is a discounting rate, and $\lambda$ is a decay rate defining how quickly the eligibility trace decays. The discounting rate $\gamma$ and the decay rate $\lambda$ are for example each equal to between 0 and 1, and in some cases either or both is for example equal to between 0.8 and 0.99.

In the operations 307 and 308, the parameter matrix $\theta$ is updated based on the output values $V_t$ resulting from the forward propagation of the state $S_t$ in the operation 303, and also based on the output values $V_{t-1}$ resulting from the forward propagation of the state $S_{t-1}$ during the operation 303 of the previous iteration, in other words at the timestep t-1.

In operation 307 (CALCULATE TD ERROR $\delta_t$), a temporal difference error value $\delta_t$ is calculated based on any reward $R_t$ received from the environment during the timestep t. For example, in one embodiment, the TD error value $\delta_t$ is calculated based on the following equation:

[Math 2]

$$\delta_t = R_t + \gamma V_t - V_{t-1}$$

where $\gamma$ is the discounting rate, $V_t$ represents the output of the value function during the timestep t, and $V_{t-1}$ represents the outputs of the value function during the previous iteration, i.e. the timestep t-1. For example, in the case of a value function $V(s)$, the output value $V_t$ is a scalar value indicating the value of the state. After simulating multiple potential states, an action is selected that leads to be best next state, in line with the NN predictions. Thus, the subtraction $\gamma V_t$-$V_{t-1}$ is a subtraction of scalars. The TD error is thus based on a difference between the predicted value $V_{t-1}$ of the neural network outputs at the previous iteration, and the discounted observed output $\gamma V_t$ during the current iteration, plus the observed reward. In case of no reward, the TD error is only based on the difference, and the weights of the neural network are still updated. In the case of Q(s,a) value functions, the output is a vector corresponding to the actions. In this case, $\gamma Q_t$-$Q_{t-1}$ is also be a subtraction of scalars, for example only taking the value that corresponded to the predicted Q of the action that was actually taken.

In an operation 308 (UPDATE SYNAPTIC WEIGHTS $\theta$), the parameter matrix $\theta$ of the DNN is for example updated based on the eligibility matrix $e$ updated in the operation 306, and based on the temporal difference error value $\delta_t$ calculated in operation 307. For example, each weight of the parameter matrix $\theta$ is updated based on the following equation:

[Math 3]

$$\theta_t = \theta_{t-1} + \alpha\delta_t e_t$$

where $\theta_t$ is the updated synaptic weight, $\theta_{t-1}$ is the previous synaptic weight, and $\alpha$ is a learning rate, for example equal to between 1e-6 and 1e-4, and for example equal to or less than 1e-5. In some embodiments, the value of $\alpha$ is chosen such that the term $\alpha\delta_t e_t$ modifies the synaptic weight $\theta_{t-1}$ by a desired quantity, corresponding for example to a few percent, for example by between 0.1 and 3 percent. The factor $\alpha\delta_t$ is for example a scalar value that is the same for all the synapses of the network.

In an operation 309 (END LEARNING PHASE?), it is determined whether a stop condition has been met in order to stop the learning phase. For example, the stop condition may be met after a certain number of iterations of the algorithm, or once the TD error $\delta_t$, for example after application of a low-pass filter, falls below a given threshold. If the stop condition is not met (branch N), a new iteration is started, involving an operation 310 (t=t+1) in which t is incremented, and thus the next timestep is considered. The method then returns to the operation 302, and the operations 302 to 309 are for example repeated. Once the stop condition of operation 309 is met (branch Y), the next operation 311 (FUNCTIONAL PHASE) for example involves switching from the learning phase to a function phase in which the parameter matrix $\theta$ for example becomes fixed, and the eligibility matrix $e$ is no longer used.

While Figure 3 illustrates a method based on discrete learning and functional phases, in alternative embodiments the method of Figure 3 could be adapted to a continuous learning approach in which the agent continues to learn throughout its lifetime.

While in the example of Figure 3, the eligibility matrix $e$ is updated in each iteration before the parameter matrix $\theta$ is updated, in alternative embodiments the parameter matrix $\theta$ could be updated before the eligibility matrix e, for example before the forward propagation step 303.

Furthermore, while in the example of Figure 3 the neural network implements a value function indicating the value V of being in each state, in alternative embodiments the neural network could implement a function indicating, at the outputs of the network, the value Q corresponding to an estimation of future expected discounted reward associated with each action. In such a case, the values $V_t$ and $V_{t-1}$ are for example replaced by $Q_t$ and $Q_{t-1}$. The scalar values of Q used in the equation correspond to the predicted Q-values of the action that was taken.

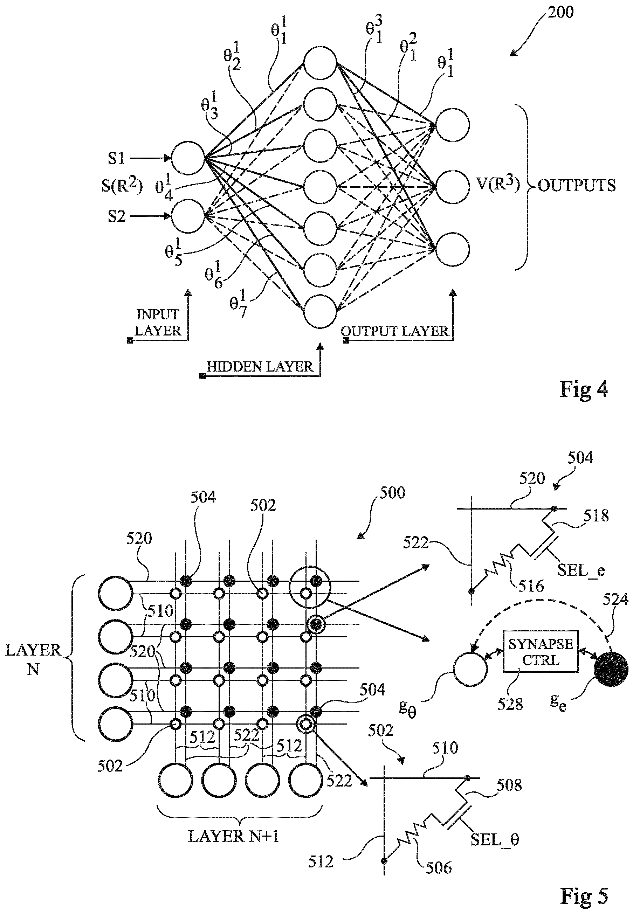

Figure 4 illustrates the DNN 200 of Figure 2 in more detail according to an example in which it is implemented by a multi-layer perceptron DNN architecture, and in which the network implements a value function V.

The DNN architecture 200 according to the example of Figure 4 comprises three layers, in particular an input layer (INPUT LAYER), a hidden layer (HIDDEN LAYER), and an output layer (OUTPUT LAYER). In alternative embodiments, there could be more than one hidden layer. Each layer for example comprises a number of neurons. For example, the DNN architecture 200 defines a model in a 2-dimensional space, and there are thus two visible neurons in the input layer receiving the corresponding values S1 and S2 representing the input state $S_t$. The model has a hidden layer with seven output hidden neurons, and thus corresponds to a matrix of dimensions $\mathbb{R}^{2*7}$. The DNN architecture 200 of Figure 4 corresponds to a value network, and the number of neurons in the output layer thus corresponds to the number of states. In the example of Figure 4, there are three neurons in the output layer. In an alternative example, the DNN 200 could implement the action value function Q, and the number of output states would then correspond to the number of actions.

The policy $V = \Pi_\theta(S)$ applied by the DNN architecture 200 is a functions aggregation, comprising an associative function $g_n$ within each layer, these functions being connected in a chain to map $V = \Pi_\theta(S) = g_n(...(g_2(g_1(S)))...))$. There are just two such functions in the simple example of Figure 4, corresponding to those of the hidden layer and the output layer.

Each neuron of the hidden layer receives the signal from each input neuron, a corresponding synaptic weight $\theta_j^i$ being applied to each neuron j of the hidden layer from each input neuron i of the input layer. Figure 4 illustrates the synaptic weights $\theta_1^1$ to $\theta_7^1$ applied to the outputs of a first of the input neurons to each of the seven hidden neurons.

Similarly, each neuron of the output layer receives the signal from each neuron of the hidden layer, a corresponding synaptic weight $\theta_j^k$ being applied to each neuron k of the output layer from each neuron j of the hidden layer. Figure 4 illustrates the synaptic weights $\theta_1^1$ to $\theta_1^3$ applied between the output of a top neuron of the hidden layer and each of the three neurons of the output layer.

Figure 5 illustrates an array 500 of synapse circuits 502, 504 interconnecting layers N (LAYER N) and N+1 (LAYER N+1) of a deep neural network, such as the network 200 of Figure 2 or Figure 4. For example, the layer N is the input layer of the network, and the layer N+1 is a first hidden layer of the network. In another example, the layers N and N+1 are both hidden layers, or the layer N is a last hidden layer of the network, and the layer N+1 is the output layer of the network.

In the example of Figure 5, the layers N and N+1 each comprise four neurons, although in alternative embodiments there could be a different number of neurons in either or both layers. The array 500 comprises a sub-array of synapse circuits 502, which each connects a corresponding neuron of the layer N to a corresponding neuron of the layer N+1, and a sub-array of synapse circuits 504, which each connect a corresponding neuron of the layer N to a corresponding neuron of the layer N+1. The synapse circuits 502 store the synaptic weights of the parameter matrix $\theta$, while the synapse circuits 504 store the eligibility traces of the eligibility matrix *e*.

Each of the synapse circuits 502 for example comprises a non-volatile memory device storing, in the form of a conductance, a synapse weight $g_\theta$ associated with the synapse circuit. The memory device of each synapse circuit 502 is for example implemented by a PCM device, or other type of resistive random-access memory (ReRAM) device, such as an oxide RAM (OxRAM) device, which is based on so-called "filamentary switching". The device for example has low or negligible drift of its programmed level of conductive over time. In the case of a PCM device, the device is for example programmed with relatively high conductance/low resistance states, which are less affected by drift than the low conductance/high resistance states. The synapse circuits 502 are for example coupled at each intersection between a pre-synaptic neuron of the layer N and a post-synaptic neuron of the layer N+1 in a cross-bar fashion, as known by those skilled in the art. For example, a blow-up view in Figure 5 illustrates an example of this intersection for the synapse circuits 502, a resistive memory device 506 being coupled in series with a transistor 508 between a line 510 coupled to a corresponding pre-synaptic neuron, and a line 512 coupled to a corresponding post-synaptic neuron. The transistor 508 is for example controlled by a selection signal SEL_$\theta$ generated by a control circuit (not illustrated in Figure 5).

During the forward propagation of the state $S_t$ through the DNN 200, each neuron n of the layer N+1 for example receives an activation vector equal to $S_{in} \cdot W$, where $S_{in}$ is the input vector from the previous layer, and *W* are the weights of the parameter matrix $\theta$ associated with the synapses leading to the neuron n. A voltage is for example applied to each of the lines 512, which is for example coupled to the top electrode of each resistive device 506 of a column and to the neuron n. The selection transistors 508 are then for example activated, such that a current will flow through each device 506 equal to $V \times g_\theta$, where V is the top electrode voltage, and $g_\theta$ is the conductance of the device 506. The current flowing through the line 512 will thus be the addition of the current flowing through each device 506 of the column, and the result is a weighted sum operation. A similar operation for example occurs at each neuron of each layer of the network, except in the input layer.

Each of the synapse circuits 504 for example comprises a volatile memory device storing, in the form of a conductance, a synapse eligibility value $g_e$ associated with the synapse circuit. The memory device of each synapse circuit 504 is for example implemented by a PCM device with pronounced drift behavior, or another type of resistive memory having a conductance decay over time, such as a silver-oxide based conductive bridge RAM element. In the case of a PCM device, the device is for example programmed with relatively low conductance/high resistance states, which have a more pronounced drift than the high conductance/low resistance states. The synapse circuits 504 are for example coupled at each intersection between a pre-synaptic neuron of the layer N and a post-synaptic neuron of the layer N+1 in a cross-bar fashion. For example, a blow-up view in Figure 5 illustrates an example of this intersection for the synapse circuits 504, a resistive memory device 516 being coupled in series with a transistor 518 between a line 520 coupled to a corresponding pre-synaptic neuron, and a line 522 coupled to a corresponding post-synaptic neuron. The transistor 518 is for example controlled by a selection signal SEL_e generated by the control circuit.

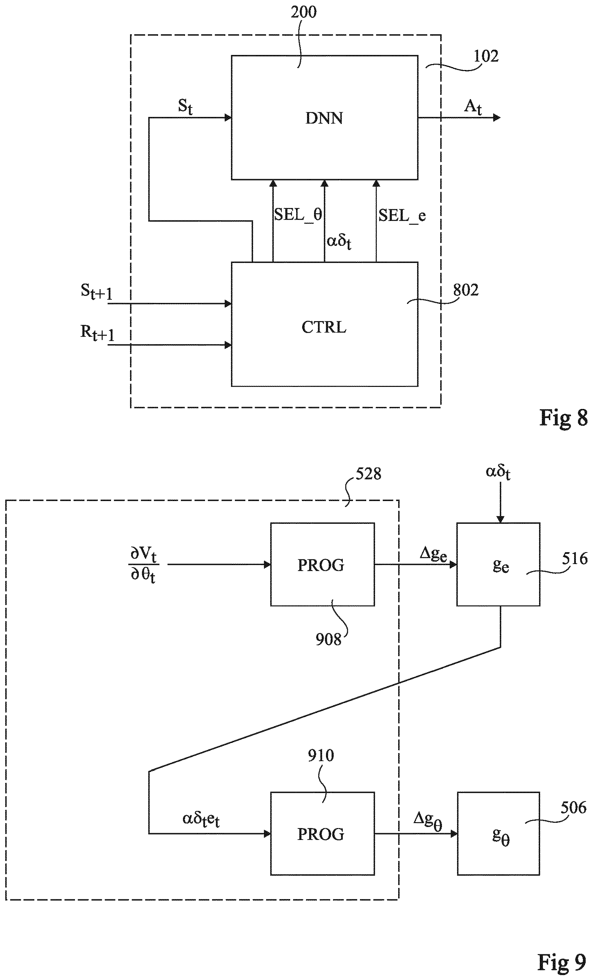

The conductance of the resistive memory elements of the pair of synapse circuits 502, 504 coupling a same pair of neurons are for example used in a complementary fashion during the updating of the synapse weight $g_\theta$, as represented by a dashed arrow 524 in Figure 5. Indeed, the conductance $g_e$ is used during the operation 308 in order to update to the synaptic weight $\theta$ in the operation 308 of Figure 3. This exchange of information between the memory devices of the synapse circuits 502, 504 is for example controlled by a synapse control circuit (SYNAPSE CTRL) 528, described in more detail below with reference to Figure 9. The conductance $g_\theta$ is also used indirectly during the updating of the conductance $g_e$. Indeed, the conductance $g_\theta$ is used during forward propagation of the state $S_t$ through the DNN 200 to generate the outputs V of the network, and the derivative of these outputs V are then back propagated and used during the operation 306 of Figure 3 to update the eligibility value $g_e$.

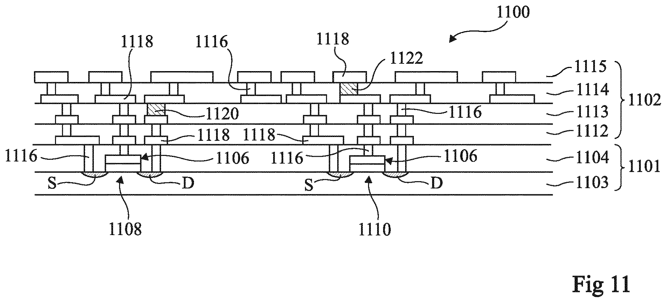

In some embodiments, the sub-arrays of synapse circuits 502, 504 are overlaid such that the corresponding synapse circuits 502, 504 are relatively close, permitting a local updating of synaptic weight $g_\theta$ of the corresponding synapse circuits. For example, the sub-arrays are integrated in a same wafer or structure, as will be described in more detail below with reference to Figure 11.

The type of resistive memory used to implement the memory devices 506, 516 of the synapse circuits 502 and 504 is for example chosen such that while programmed conductance levels of the memory devices storing the conductances $g_\theta$ decay relatively little over time, the conductance levels of the memory devices storing the conductances $g_e$ have a relatively high rate of decay. For example, the two memory devices 506, 516 of the synapse circuits 502 are implemented by different technologies of resistive memory device, one providing non-volatile storage, and the other providing volatile storage with a relatively high decay rate. Alternatively, the two memory devices 506, 516 of the synapse circuits 502 are implemented by the same technology of resistive memory device, such as PCM technology, and the decay rates are varied between the devices by other means, such as by using different conductance ranges.

The use of a relatively high conductance decay rate for the memory device 516 storing the conductance $g_e$ provides a simple and effective implementation of the decay rate $\lambda$, without the need of further circuitry such as timers, etc. Furthermore, it for example allows the multiplication of the eligibility value $e$ with the learning rate $\gamma$ and the TD error $\delta_t$ in an analog manner, leading to a simple and low-power solution.

While in Figure 5 the sub-array of synapse circuits 504 has been illustrated arranged in a similar configuration to the synapse circuits 502, it will be apparent to those skilled in the art that any arrangement that permits the memory cells of the circuit to be accessed and selectively programmed could be implemented. For example, rather than having orthogonal source and bit lines, the source and bit lines could be parallel to each other, an orthogonal word line for example being used to select the gate of transistors.

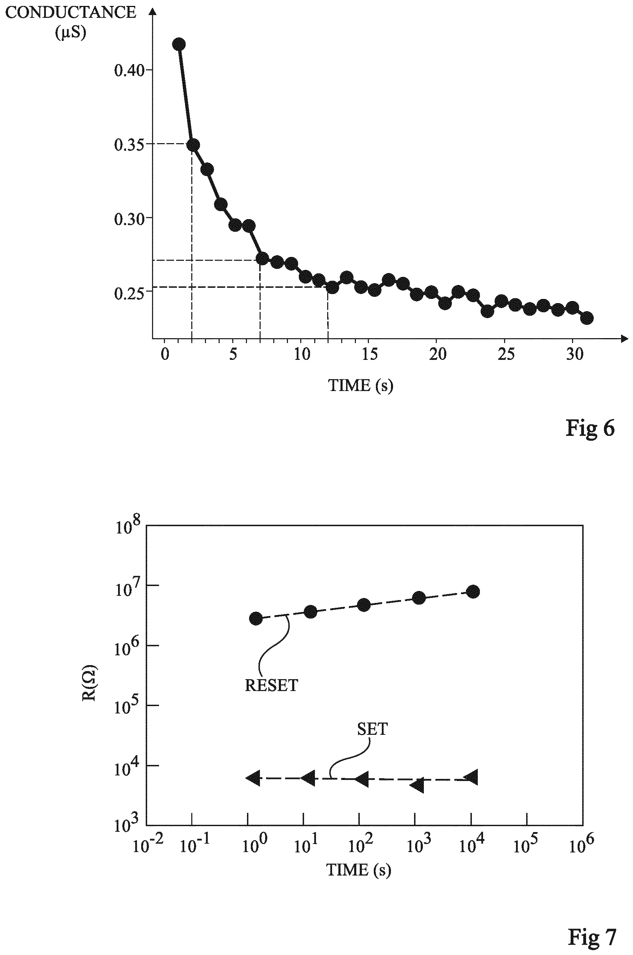

The drift of a PCM device will now be described in more detail with reference to Figures 6 and 7.

Figure 6 is a graph illustrating an example of conductance drift of a phase change memory device over time. In particular, for a PCM device that has its resistance state reset to a high resistive state (HRS) at a time t0 and is left drifting for 30 seconds, it can be observed that the conductivity presents a power law decay, the time-constant of which depends on the reset conditions. In the example embodiment, the conductance is at around 0.35 $\mu$S after 2 s, and has fallen to around 0.27 $\mu$S after 7 s, and to around 0.255 $\mu$S after 12 s. Thus, the conductance drift substantially follows a relation of 1/t.

The phase-change memory devices are for example chalcogenide-based devices, in which the resistive switching layer is formed of polycrystalline chalcogenide, placed in contact with a heater.

As known by those skilled in the art, a reset operation of a PCM device involves applying a relatively high current through the device for a relatively short duration. For example, the duration of the current pulse is of less than 10 ns. This causes a melting of a region of a resistive switching layer of the device, which then changes from a crystalline phase to an amorphous phase, and then cools without recrystallizing. This amorphous phase has a relatively high electrical resistance. Furthermore, this resistance increases with time following the reset operation, corresponding to a decrease in the conductance of the device. Such a drift is for example particularly apparent when the device is reset using a relatively high current, leading to a relatively high initial resistance, and a higher subsequent drift. Those skilled in the art will understand how to measure the drift that occurs based on different reset states, i.e. different programming currents, and will then be capable of choosing a suitable programming current that results in an amount of drift that can be exploited as described herein.

As also known by those skilled in the art, a set operation of a PCM device involves applying a current that is lower than the current applied during the reset operation, for a longer duration. For example, the duration of the current pulse is of more than 100 ns. This for example causes the amorphous region of the resistive switching layer of the device to change from the amorphous phase back to the crystalline phase as the current reduces. The resistance of the device is thus relatively low.

Figure 7 is a graph illustrating, on a logarithmic scale, an example of a drift in a resistance of a phase-change memory device over time in the set (SET) and reset (RESET) states. It can be seen that, whereas the resistance varies relatively little in the set state, there is a relatively high increase over time in the reset state. For example, the resistance R in both the set and reset states substantially follows the model $R = R_0(t/t_0)^v$, where $R_0$ is the initial resistance at time $t_0$. In the case of the set state, the parameter $v$ is for example of less than 0.01, whereas for the reset state, the parameter $v$ is for example over 0.1, and for example equal to around 0.11.

Figure 8 schematically illustrates the agent 102 of Figures 1 and 2 in more detail according to an example embodiment of the present disclosure. For example, in addition to the DNN 200, the agent 102 comprises a control circuit (CTRL) 602 that receives the state $S_{t+1}$ and the reward $R_{t+1}$ from the environment 104, and provides to the DNN 200 the state $S_t$ and a scalar value equal to $\alpha\delta_t$. The control circuit 802 also for example provides the control signals SEL_$\theta$ and SEL_$e$ to the DNN 200 to control the different phases.

Figure 9 schematically illustrates part of a synapse circuit in more detail according to an example embodiment, and illustrates in particular memory devices 506, 516 of the synapse circuits 502, 504 respectively, which respectively store the conductances $g_e$ and $g_\theta$, and the synapse control circuit 528.

During the operations 305 and 306 of Figure 3, the derivative $\partial V_t/\partial\theta_t$ associated with the neuron and resulting from the backpropagation through the network is for example provided to a programming circuit (PROG) 908, which generates a control signal $\Delta g_e$ for modifying the conductance of the memory device 516. In view of the drift over time of the conductance of the memory device 516, the new conductance thus becomes $g_e = \gamma\lambda g_{e t-1} + \Delta g_e$, where $\gamma\lambda$ is represented by the decay rate of the memory device 516. Alternatively, in the case that the memory device 516 is capable of only being reset, a decision is for example made by the programming circuit 908 of whether or not to reset the resistive state of the device 516 based on the value of the derivative $\partial V_t/\partial\theta_t$. For example, this involves comparing the value of the derivative $\partial V_t/\partial\theta_t$ with a threshold, and if the threshold is exceeded, the device 516 is reset, whereas otherwise no action is taken. It would also be possible to read a current value of the conductivity $\gamma\lambda g_{e t-1}$. In this case, $\gamma\lambda g_{e t-1} + \Delta g_e$ can be evaluated and compared with a threshold in order to decide whether or not to reset the conductance of the memory device.

During the operation 308 of Figure 3, the memory device 516 for example receives the value $\alpha\delta_t$, which is for example in the form of an analog voltage level generated by a digital to analog converter (DAC - not illustrated in Figure 9). Applying this signal to the memory device 516, for example to its top electrode, causes a current to be generated that is a function of this voltage and of the conductance $g_e$ of the device 516. Thus, the current represents $\alpha\delta e_t$. The value $\alpha\delta e_t$ is for example provided to a programming circuit (PROG) 910, which generates a control signal $\Delta g_\theta$ for modifying the conductance of the corresponding memory device 506 based on the value $\alpha\delta e_t$. For example, the new conductance thus becomes $g_{\theta t} = g_{\theta t-1} + \Delta g_\theta$. While the above example is based on the use of an analog voltage level to represent $\alpha\delta_t$, in alternative embodiments, it would also be possible to represent this as an analog current level, the voltage across the memory device then representing the output $\alpha\delta e_t$.

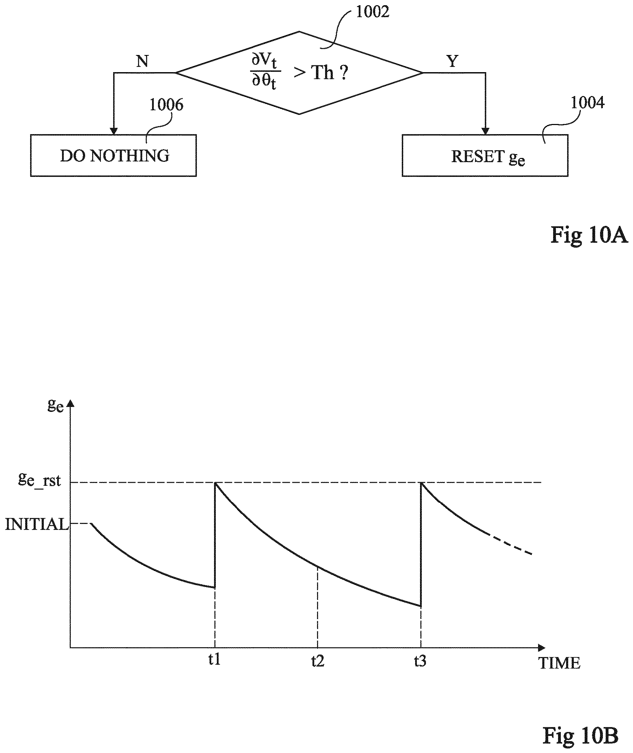

Figure 10A is a flow diagram illustrating operations in a method of storing an eligibility trace to the memory device 516 of Figure 9, according to an example in which a resistive state of the memory device is selectively reset.

In an operation 1002, the value of the derivative $\partial V_t/\partial\theta_t$ is compared to a threshold Th. If the threshold is exceeded (branch Y), the conductance $g_e$ of the memory device is reset in an operation 1004 (RESET $g_e$). Otherwise (branch N), the conductance of the memory device 516 is not modified, as shown by an operation 1006 (DO NOTHING).

Figure 10B is a timing diagram representing variation of the conductance $g_e$ of the memory device 516 storing an eligibility trace as a function of time (TIME) according to an example embodiment, over three iterations corresponding to timesteps t1, t2 and t3. The conductance $g_e$ for example starts at an initial value INITIAL, and decays until the timestep t1. A value of the derivative $\partial V_t/\partial\theta_t$ is then compared to the threshold Th, which is exceeded, and thus the conductance is reset to a reset level $g_{e\_rst}$. The conductance $g_e$ then for example decays until the timestep t2. This time the value of the derivative $\partial V_t/\partial\theta_t$ does not exceed the threshold Th, and thus no action is taken, and the conductance $g_e$ continues to decay until the timestep t3. A value of the derivative $\partial V_t/\partial\theta_t$ is then compared to the threshold Th, which is exceeded, and thus the conductance is reset again to the reset level $g_{e\_rst}$.

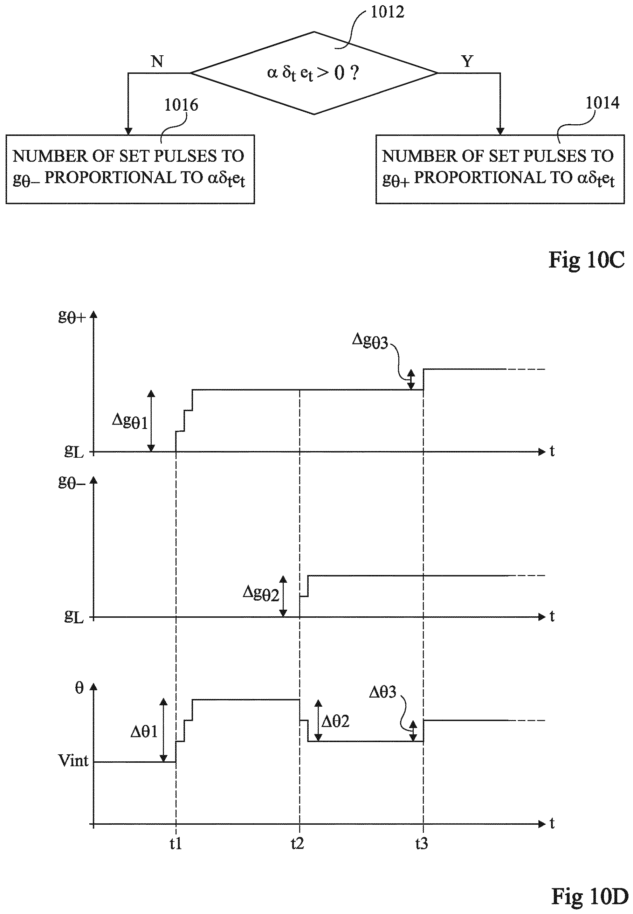

Figure 10C is a flow diagram illustrating operations in a method of storing a synaptic weight to the memory device 506 of Figure 9, according to an example in which the memory device 506 storing the synaptic weight $\theta$ formed by two devices respectively having conductances $g_{\theta+}$ and $g_{\theta-}$. Each of these devices is for example of a technology permitting its conductance to be increased gradually using programming pulses, for example during a set operation. However, decreasing the conductance is for example performed by an abrupt reset operation. For example, the memory device is a PCM device or an OxRAM device. The method of Figure 10C is for example implemented by the programming circuit 910 of Figure 9.

In an operation 1012, the output $\alpha\delta e_t$ from the memory device 516 is positive or negative, indicating whether the synaptic weight $\theta$ should be increased or reduced. Indeed, in some embodiments, the parameters $e_t$ and/or $\delta$ may have positive or negative values. For example, this comparison is performed in an analog manner using a comparator. If the output $\alpha\delta e_t$ is positive (branch Y), in an operation 1014 (NUMBER OF SET PULSES TO $g_{\theta+}$ PROPORTIONAL TO $\alpha\delta_t e_t$), a number of SET pulses is applied to the memory device of conductance $g_{\theta+}$ in order to increase the conductance of this device. Alternatively, if the output $\alpha\delta e_t$ is negative (branch N), in an operation 1016 (NUMBER OF SET PULSES TO $g_{\theta-}$ PROPORTIONAL TO $\alpha\delta_t e_t$), a number of SET pulses is applied to the memory device of conductance $g_{\theta-}$ in order to increase the conductance of this device. The overall conductance $g_\theta$ for example results from the combined conductances of the two memory devices, as will now be described with reference to Figure 10D.

Figure 10D is a timing diagram representing examples of the conductances $g_{\theta-}$ and $g_{\theta+}$ and of the corresponding value of the synaptic weight $\theta$, equal for example to a difference between the conductances $g_{\theta-}$ and $g_{\theta+}$, plus an offset.

Initially, it is assumed that both memory devices have a low conductance of $g_L$, and that this corresponds to an intermediate value Vint of the synaptic weight $\theta$.

At a timestep t1, it is for example found that the output value $\alpha\delta e_{t1}$ is positive, and thus the conductance $g_{\theta+}$ is increased by an amount $\Delta g_{\theta 1}$, for example by applying three consecutive current or voltage pulses to the corresponding memory device based on the magnitude of $\alpha\delta e_{t1}$, and the synaptic weight thus increases by a corresponding amount $\Delta\theta 1$.

At a timestep t2, it is for example found that the output value $\alpha\delta e_{t2}$ is negative, and thus the conductance $g_{\theta-}$ is increased by an amount $\Delta g_{\theta 2}$, for example by applying two consecutive current or voltage pulses to the corresponding memory device based on the magnitude of $\alpha\delta e_{t2}$, and the synaptic weight thus decreases by a corresponding amount $\Delta\theta 2$.

At a timestep t3, it is for example found that the output value $\alpha\delta e_{t3}$ is positive, and thus the conductance $g_{\theta+}$ is increased by an amount $\Delta g_{\theta 3}$, for example by applying a single current or voltage pulse to the corresponding memory device based on the magnitude of $\alpha\delta e_{t3}$, and the synaptic weight thus increases by a corresponding amount $\Delta\theta 3$.

Figure 11 is a cross-section view illustrating a transistor layer 1101 and a metal stack 1102 forming a portion 1100 of a deep neural network, and illustrates an example of the co-integration of two types of resistive memory devices. For example, such a structure is used to form the array 500 of Figure 5 comprising the devices 506 and 516 of Figure 9. The device 506 stores the synaptic weight $\theta$ and has relatively low conductance decay, for example corresponding to a non-volatile behavior, and the device 516 stores the eligibility trace e and for example has a relatively high conductance decay, for example corresponding to a volatile behavior.

The transistor layer 1101 is formed of a surface region 1103 of a silicon substrate in which transistor sources and drains S, D, are formed, and a transistor gate layer 1104 in which gate stacks 1106 of the transistors are formed. Two transistors 1108, 1110 are illustrated in the example of Figure 11.

The metal stack 1102 comprises four interconnection levels 1112, 1113, 1114 and 1115 in the example of Figure 11, each interconnection level for example comprising a patterned metal layer 1118 and metal vias 1116 coupling metal layers, surrounded by a dielectric material. Furthermore, metal vias 1116 for example extend from the source, drain and gate contacts of the transistors 1108, 1110 to the metal layer 1118 of the interconnection level 1112.

In the example of Figure 11, a restive memory device 1120 of a first type, is formed in the interconnection level 1113, and for example extends between the metal layers 1118 of the interconnection levels 1113 and 1114. This device 1120 for example corresponds to the device 516 of Figure 9. A resistive memory device 1122 of a second type is formed in the interconnection level 1114, and for example extends between the metal layers 1118 of the interconnection levels 1114 and 1115. This device 1122 for example corresponds to the device 506 of Figure 9.

An advantage of the embodiments described herein is that TD-lambda temporal difference learning using a neural network to approximate a value function can be implemented by a DNN with relatively low complexity, using relatively compact and low-cost circuitry. In particular, the values of the synaptic weights $\theta$ can be updated locally at the synapses based on the corresponding eligibility trace e, leading to gains in terms of complexity, surface area, cost, and also power consumption.

Various embodiments and variants have been described. Those skilled in the art will understand that certain features of these embodiments can be combined and other variants will readily occur to those skilled in the art. In particular, it will be apparent to those skilled in the art that, while certain examples of resistive memory types have been provided, other technologies could also be used to implement the memory devices of the DNN. Furthermore, while the example of a DNN has been described, the implementation of the agent is not limited to a DNN, and other types of neural networks could equally be used.

Finally, the practical implementation of the embodiments and variants described herein is within the capabilities of those skilled in the art based on the functional description provided hereinabove.

**Claims**

1. A synapse circuit (502, 504) of a neural network (200) for performing TD-lambda temporal difference learning, the neural network approximating a value function (V(s), Q(s,a)), the synapse circuit comprising:

   a first resistive memory device (506);
   a second resistive memory device (516); and
   a synapse control circuit (528) configured to update a synaptic weight ($g_\theta$, $g_{\theta+}$, $g_{\theta-}$) of the synapse circuit by programming a resistive state of the first resistive memory device (506) based on a programmed conductance of the second resistive memory device (516) which stores an eligibility trace of the synapse circuit,
   wherein the synapse control circuit (528) is further configured to update the eligibility trace of the synapse circuit by programming a resistive state of the second resistive memory device (516) based on a back-propagated derivative ($\partial V_t / \partial \theta_t$) of an output value ($V_t$) of the neural network (200).

2. The synapse circuit of claim 1, wherein the second resistive memory device (516) is configured to have a conductance ($\gamma\lambda$) that decays over time.

3. The synapse circuit of claim 2, wherein the second resistive memory device (516) is a phase-change memory device or a conductive bridging RAM element.

4. The synapse circuit (502, 504) of any of claims 1 to 3, wherein the synapse control circuit (528) is configured to update the synaptic weight ($g_\theta$, $g_{\theta+}$, $g_{\theta-}$) by applying a voltage or current level generated based on a temporal difference error ($\delta$) to an electrode of the second resistive memory device (516) to generate an output current or voltage level.

5. The synapse circuit of claim 4, wherein the synapse control circuit (528) is further configured to compare the output current or voltage level with one or more thresholds, and to program the resistive state of the first resistive memory device based on the comparison.

6. An agent device (102) of a TD-lambda temporal difference learning system, the agent device (102) comprising a neural network (200) comprising an input layer of neurons, one or more hidden layers of neurons, and an output layer of neurons, wherein:

   - each neuron of the input layer is coupled to one or more neurons of a first hidden layer of the one or more hidden layers via a corresponding synapse circuit (502, 504) implemented by the circuit of claim 4 or 5.

7. The agent device (102) of claim 6, further comprising a control circuit (802) configured to generate the temporal difference error ($\delta$) based on a reward signal ($R_t$) received from the environment (104), and to provide the temporal difference error ($\delta$) to the neural network (200).

8. The agent device of claim 7, wherein the control device (802) provides to the neural network a signal representative of the product of the temporal difference error ($\delta$) and a learning rate ($\alpha$).

9. A system for TD-lambda temporal difference learning comprising:

   - the agent device (102) of any of claims 6 to 8 configured to generate an output signal indicating an action ($A_t$) to be applied to an environment based on an output of the neural network (200);
   - one or more actuators configured to apply the action ($A_t$) to the environment; and
   - one or more sensors configured to detect a state ($S_{t+1}$) of the environment and a reward ($R_{t+1}$) resulting from the action ($A_t$).

10. A method of TD-lambda temporal difference learning, the method comprising:

    - updating a synaptic weight ($g_\theta$, $g_{\theta+}$, $g_{\theta-}$) of a synapse circuit (502, 504) of a neural network (200), the neural network approximating a value function (V(s), Q(s,a)), the synapse circuit comprising: a first resistive memory device (506); a second resistive memory device (516); and a synapse control circuit (528),
    wherein updating the synaptic weight comprises programming, by the synapse control circuit (528), a resistive state of the first resistive memory device (506) based on a programmed conductance of the second resistive memory device (516) which stores an eligibility trace of the synapse circuit; and

- updating, by the synapse control circuit (528), the eligibility trace of the synapse circuit by programming a resistive state of the second resistive memory device (516) based on a back-propagated derivative ($\partial V_t/\partial \theta_t$) of an output value ($V_t$) of the neural network (200).

11. The method of claim 10, wherein the second resistive memory device (516) is configured to have a conductance ($\gamma \lambda$) that decays over time.

12. The method of claim 10 or 11, wherein updating the synaptic weight ($g_\theta$, $g_{\theta+}$, $g_{\theta-}$) comprises applying a voltage or current level generated based on a temporal difference error ($\delta$) to an electrode of the second resistive memory device (516) in order to generate an output current or voltage level.

13. The method of claim 12, further comprising comparing, by the synapse control circuit (528), the output current or voltage level with one or more thresholds, and programming the resistive state of the first resistive memory device (506) based on the comparison.

**Patentansprüche**

1. Eine Synapsenschaltung (502, 504) eines neuronalen Netzwerks (200) zum Durchführen von TD-Lambda-Zeitdifferenzlernen, wobei das neuronale Netzwerk eine Wertfunktion (V(s), Q(s,a)) approximiert, wobei die Synapsenschaltung Folgendes aufweist:

eine erste resistive Speichervorrichtung (506);
eine zweite resistive Speichervorrichtung (516); und
eine Synapsensteuerschaltung (528), die konfiguriert ist zum Aktualisieren einer synaptischen Gewichtung ($g_\theta$, $g_{\theta+}$,$g_{\theta-}$) der Synapsenschaltung durch Programmieren eines resistiven Zustands der ersten resistiven Speichervorrichtung (506) basierend auf einem programmierten Leitwert der zweiten resistiven Speichervorrichtung (516), die eine Elegibilitätsspur der Synapsenschaltung speichert, wobei die Synapsensteuerschaltung (528) ferner konfiguriert ist zum Aktualisieren der Elegibilitätsspur der Synapsenschaltung durch Programmieren eines resistiven Zustands der zweiten resistiven Speichervorrichtung (516) basierend auf einer rückgekoppelten Ableitung ($\partial V_t/\partial \theta_t$) eines Ausgangswerts ($V_t$) des neuronalen Netzwerks (200).

2. Die Synapsenschaltung nach Anspruch 1, wobei die zweite resistive Speichervorrichtung (516) konfiguriert ist, einen Leitwert ($\gamma \lambda$) zu haben, der mit der Zeit abnimmt.

3. Die Synapsenschaltung nach Anspruch 2, wobei die zweite resistive Speichervorrichtung (516) eine Phasenwechsel-Speichervorrichtung oder ein leitendes Brücken-RAM-Element ist.

4. Die Synapsenschaltung (502, 504) nach einem der Ansprüche 1 bis 3, wobei die Synapsensteuerschaltung (528) konfiguriert ist zum Aktualisieren der synaptischen Gewichtung ($g_\theta$,$g_{\theta+}$,$g_{\theta-}$) durch Anlegen eines Spannungs- oder Strompegels, der basierend auf einem zeitlichen Differenzfehler ($\delta$) generiert wird, und zwar an eine Elektrode der zweiten resistiven Speichervorrichtung (516), um einen Ausgangsstrom- oder Spannungspegel zu generieren.

5. Die Synapsenschaltung nach Anspruch 4, wobei die Synapsensteuerschaltung (528) ferner konfiguriert ist zum Vergleichen des Ausgangsstroms oder -spannungspegels mit einem oder mehreren Schwellenwerten und zum Programmieren des resistiven Zustands der ersten resistiven Speichervorrichtung basierend auf dem Vergleich.

6. Eine Agentenvorrichtung (102) eines TD-Lambda-Zeitdifferenz-Lernsystems, wobei die Agentenvorrichtung (102) ein neuronales Netzwerk (200) aufweist, das eine Eingangsebene von Neuronen, eine oder mehrere versteckte Ebenen von Neuronen und eine Ausgangsebene von Neuronen aufweist, wobei:

- jedes Neuron der Eingangsebene mit einem oder mehreren Neuronen einer ersten versteckten Ebene der einen oder mehreren versteckten Ebenen über eine entsprechende Synapsenschaltung (502, 504) gekoppelt ist, die durch die Schaltung nach Anspruch 4 oder 5 implementiert ist.

7. Die Agentenvorrichtung (102) nach Anspruch 6, ferner aufweisend eine Steuerschaltung (802), die konfiguriert ist zum Generieren des zeitlichen Differenzfehlers ($\delta$) basierend auf einem Belohnungssignal ($R_t$), das von der Um-gebung (104) empfangen wird, und zum Bereitstellen des zeitlichen Differenzfehlers () an das neuronale Netzwerk (200).

8. Die Agentenvorrichtung nach Anspruch 7, wobei die Steuervorrichtung (802) dem neuronalen Netzwerk ein Signal bereitstellt, das repräsentativ für das Produkt aus dem zeitlichen Differenzfehler ($\delta$) und einer Lernrate ($\alpha$) ist.

9. Ein System für TD-Lambda-Zeitdifferenz-Lernen, das Folgendes aufweist:

- die Agentenvorrichtung (102) nach einem der Ansprüche 6 bis 8, die konfiguriert ist zum Generieren eines Ausgangssignals, das eine auf eine Umgebung anzuwendende Aktion ($A_t$) anzeigt, basierend auf einem Ausgang des neuronalen Netzwerks (200),
- einen oder mehrere Aktuatoren, die konfiguriert sind zum Ausüben der Aktion ($A_t$) auf die Umgebung; und
- einen oder mehrere Sensoren, die konfiguriert sind zum Detektieren eines Zustands ($S_{t+1}$) der Umgebung und einer Belohnung ($R_{t+1}$), die aus der Aktion ($A_t$) resultiert.

10. Ein Verfahren zum TD-Lambda-Zeitdifferenz-Lernen, wobei das Verfahren Folgendes aufweist:

- Aktualisieren einer synaptischen Gewichtung ($g_\theta, g_{\theta+}, g_{\theta-}$) einer Synapsenschaltung (502, 504) eines neuronalen Netzwerks (200), wobei das neuronale Netzwerk eine Wertfunktion (V(s), Q(s,a)) approximiert, wobei die Synapsenschaltung Folgendes aufweist: eine erste resistive Speichervorrichtung (506); eine zweite resistive Speichervorrichtung (516); und eine Synapsensteuerschaltung (528),
wobei das Aktualisieren der synaptischen Gewichtung Programmieren, durch die Synapsensteuerschaltung (528), eines resistiven Zustands der ersten resistiven Speichervorrichtung (506) aufweist, und zwar basierend auf einem programmierten Leitwert der zweiten resistiven Speichervorrichtung (516), die eine Eligibilitätsspur der Synapsenschaltung speichert; und
- Aktualisieren, durch die Synapsensteuerschaltung (528), der Eligibilitätsspur der Synapsenschaltung durch Programmieren eines resistiven Zustands der zweiten resistiven Speichervorrichtung (516) basierend auf einer rückgekoppelten Ableitung ($\partial V_t / \partial \theta_t$) eines Ausgangswerts ($V_t$) des neuronalen Netzwerks (200).

11. Das Verfahren nach Anspruch 10, wobei die zweite resistive Speichervorrichtung (516) konfiguriert ist, eine Leitfähigkeit ($\gamma\lambda$) zu haben, die mit der Zeit abnimmt.

12. Das Verfahren nach Anspruch 10 oder 11, wobei Aktualisieren der synaptischen Gewichtung ($g_\theta, g_{\theta+}, g_{\theta-}$) Anlegen eines Spannungs- oder Strompegels aufweist, der basierend auf einem zeitlichen Differenzfehler ($\delta$) an eine Elektrode der zweiten resistiven Speichervorrichtung (516) erzeugt wird, um einen Ausgangsstrom oder Spannungspegel zu erzeugen.

13. Das Verfahren nach Anspruch 12 ferner aufweisend Vergleichen, durch die Synapsensteuerschaltung (528), des Ausgangsstroms oder Spannungspegels mit einem oder mehreren Schwellenwerten und Programmieren des resistiven Zustands der ersten resistiven Speichervorrichtung (506) basierend auf dem Vergleich.

**Revendications**

1. Circuit de synapse (502, 504) d'un réseau neuronal (200) destiné à effectuer un apprentissage par différence temporelle TD-lambda, le réseau neuronal approchant une fonction de valeur (V(s), Q(s,a)), le circuit de synapse comprenant :

un premier dispositif de mémoire résistive (506) ;
un deuxième dispositif de mémoire résistive (516) ; et
un circuit de commande de synapse (528) configuré pour mettre à jour une pondération synaptique ($g_\theta, g_{\theta+}, g_{\theta-}$) du circuit de synapse en programmant un état résistif du premier dispositif de mémoire résistive (506) sur la base d'une conductance programmée du deuxième dispositif de mémoire résistive (516) qui stocke une trace d'éligibilité du circuit de synapse,
dans lequel le circuit de commande de synapse (528) est en outre configuré pour mettre à jour la trace d'éligibilité du circuit de synapse en programmant un état résistif du deuxième dispositif de mémoire résistive (516) sur la base d'une dérivée rétro-propagée ($\partial V_t / \partial \theta_t$) d'une valeur de sortie ($V_t$) du réseau neuronal (200).

2. Circuit de synapse selon la revendication 1, dans lequel le deuxième dispositif de mémoire résistive (516) est configuré pour avoir une conductance ($\gamma\lambda$) qui décroît au cours du temps.

3. Circuit de synapse selon la revendication 2, dans lequel le deuxième dispositif de mémoire résistive (516) est un dispositif de mémoire à changement de phase ou un élément RAM de pont conducteur.

4. Circuit de synapse (502, 504) selon l'une quelconque des revendications 1 à 3, dans lequel le circuit de commande de synapse (528) est configuré pour mettre à jour la pondération synaptique ($g_\theta$, $g_{\theta+}$, $g_{\theta-}$) en appliquant un niveau de tension ou de courant généré sur la base d'une erreur de différence temporelle ($\delta$) à une électrode du deuxième dispositif de mémoire résistive (516) pour générer un niveau de courant ou de tension de sortie.

5. Circuit de synapse selon la revendication 4, dans lequel le circuit de commande de synapse (528) est en outre configuré pour comparer le niveau de courant ou de tension de sortie avec un ou plusieurs seuils, et pour programmer l'état résistif du premier dispositif de mémoire résistive sur la base de la comparaison.

6. Dispositif agent (102) d'un système d'apprentissage par différence temporelle TD-lambda, le dispositif agent (102) comprenant un réseau neuronal (200) comprenant une couche d'entrée de neurones, une ou plusieurs couches cachées de neurones et une couche de sortie de neurones, dans lequel :

   - chaque neurone de la couche d'entrée est relié à un ou plusieurs neurones d'une première couche cachée parmi les une ou plusieurs couches cachées par l'intermédiaire d'un circuit de synapse correspondant (502, 504) mis en œuvre par le circuit selon la revendication 4 ou 5.

7. Dispositif d'agent (102) selon la revendication 6, comprenant en outre un circuit de commande (802) configuré pour générer l'erreur de différence temporelle ($\delta$) sur la base d'un signal de récompense ($R_t$) reçu en provenance de l'environnement (104), et pour fournir l'erreur de différence temporelle ($\delta$) au réseau neuronal (200).

8. Dispositif agent selon la revendication 7, dans lequel le dispositif de commande (802) fournit au réseau neuronal un signal représentatif du produit de l'erreur de différence temporelle ($\delta$) et d'un taux d'apprentissage ($\alpha$).

9. Système d'apprentissage par différence temporelle TD-lambda comprenant :

   - le dispositif agent (102) selon l'une quelconque des revendications 6 à 8 configuré pour générer un signal de sortie indiquant une action ($A_t$) à appliquer à un environnement sur la base d'une sortie du réseau neuronal (200) ;
   - un ou plusieurs actionneurs configurés pour appliquer l'action ($A_t$) à l'environnement ; et
   - un ou plusieurs capteurs configurés pour détecter un état ($S_{t+1}$) de l'environnement et une récompense ($R_{t+1}$) résultant de l'action ($A_t$).

10. Procédé d'apprentissage par différence temporelle TD-lambda, le procédé comprenant :

    - la mise à jour d'une pondération synaptique ($g_\theta$, $g_{\theta+}$, $g_{\theta-}$) d'un circuit de synapse (502, 504) d'un réseau neuronal (200), le réseau neuronal approchant une fonction de valeur (V(s), Q(s,a)), le circuit de synapse comprenant : un premier dispositif de mémoire résistive (506) ; un deuxième dispositif de mémoire résistive (516) ; et un circuit de commande de synapse (528),
    dans lequel la mise à jour de la pondération synaptique comprend la programmation, par le circuit de commande de synapse (528), d'un état résistif du premier dispositif de mémoire résistive (506) sur la base d'une conductance programmée du deuxième dispositif de mémoire résistive (516) qui stocke une trace d'éligibilité du circuit de synapse,
    - la mise à jour, par le circuit de commande de synapse (528), de la trace d'éligibilité du circuit de synapse en programmant un état résistif du deuxième dispositif de mémoire résistive (516) sur la base d'une dérivée rétro-propagée ($\partial V_t/\partial\theta_t$) d'une valeur de sortie ($V_t$) du réseau neuronal (200).

11. Procédé selon la revendication 10, dans lequel le deuxième dispositif de mémoire résistive (516) est configuré pour avoir une conductance ($\gamma\lambda$) qui décroît au cours du temps.

12. Procédé selon l'une quelconque des revendications 10 à 11, dans lequel la mise à jour de la pondération synaptique ($g_\theta$, $g_{\theta+}$, $g_{\theta-}$) comprend l'application d'un niveau de tension ou de courant généré sur la base d'une erreur de différence temporelle ($\delta$) à une électrode du deuxième dispositif de mémoire résistive (516) afin de générer un niveau de courant ou de tension de sortie.

**13.** Procédé selon la revendication 12, comprenant en outre la comparaison, par le circuit de commande de synapse (528), du niveau de courant ou de tension de sortie avec un ou plusieurs seuils, et la programmation de l'état résistif du premier dispositif de mémoire résistive (506) sur la base de la comparaison.

Fig 1

Fig 2

INITIALISE $\theta$ AND e — 301

RECEIVE STATE $S_t$ AND
ANY REWARD $R_t$ — 302

FORWARD PROPAGATE STATE $S_t$ — 303

DETERMINE + APPLY
ACTION $A_t$ — 304

BACK PROPAGATE DERIVATIVE
$\partial V_t / \partial \theta_t$ — 305

UPDATE ELIGIBILITY e :
$e_t = e_{t-1}\gamma\lambda + \dfrac{\partial V_t}{\partial \theta_t}$ — 306

CALCULATE TD ERROR $\delta_t$:
$\delta_t = R_t + \gamma V_t - V_{t-1}$ — 307

UPDATE SYNAPTIC WEIGHTS $\theta$ :
$\theta_t = \theta_{t-1} + \alpha\delta_t e_t$ — 308

$t = t + 1$ — 310

END
LEARNING PHASE ? — 309

N

Y

FUNCTIONAL
PHASE — 311

Fig 3

Fig 4

Fig 5

Fig 6

Fig 7

Fig 8

Fig 9

Fig 10A

Fig 10B

Fig 10C

Fig 10D

Fig 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **TESAURO, GERALD**. TD-Gammon, a self-teaching backgammon program, achieves master-level play. *Neural computation*, 1994, vol. 6 (2), 215-219
- **MOUSAVI** ; **SEYED SAJAD et al.** Applying q (λ)-learning in deep reinforcement learning to play atari games. *AAMAS Adaptive Learning Agents (ALA) Workshop*, 2017
- **YIGIT DEMIRAG et al.** *PCM-trace: Scalable Synaptic Eligibility Traces with Resistivity Drift of Phase-Change Materials*, 16 February 2021